# FASCICULE DE BREVET EUROPEEN

(11) **EP 2 725 709 B1**
(45) Date de publication et mention de la délivrance du brevet: **17.06.2015**
(21) Numéro de dépôt: 12190219.1
(22) Date de dépôt: 26.10.2012
(51) Int. Cl.: H03F 3/45, H03G 3/30

(54) **Circuit électronique pour la commande automatique du gain à double pente d'un amplificateur**
Elektronischer Schaltkreis für die automatische Verstärkungsregelung mit zwei Steigungen bei einem Verstärker
Electronic circuit for automatic gain control with dual slope of an amplifier

(43) Date de publication de la demande: 30.04.2014
(73) Titulaire: EM Microelectronic-Marin SA, 2074 Marin (CH)
(72) Inventeur: Tajalli, Armin, 1022 Chavannes-près-Renens (CH)
(74) Mandataire: Ravenel, Thierry Gérard Louis

(56) Documents cités:
- EP-A2- 0 342 671
- US-A1- 2009 072 904
- US-A1- 2009 117 868
- US-A1- 2012 235 744

## Description

### DOMAINE TECHNIQUE

La présente invention concerne un circuit électronique pour la commande automatique du gain d'un amplificateur. Le gain de l'amplificateur d'entrée du circuit électronique est adapté dans une boucle de commande automatique du gain, en particulier avec une adaptation à double pente pour augmenter la vitesse d'adaptation du gain et maintenir la stabilité du circuit électronique.

### ARRIERE-PLAN TECHNOLOGIQUE

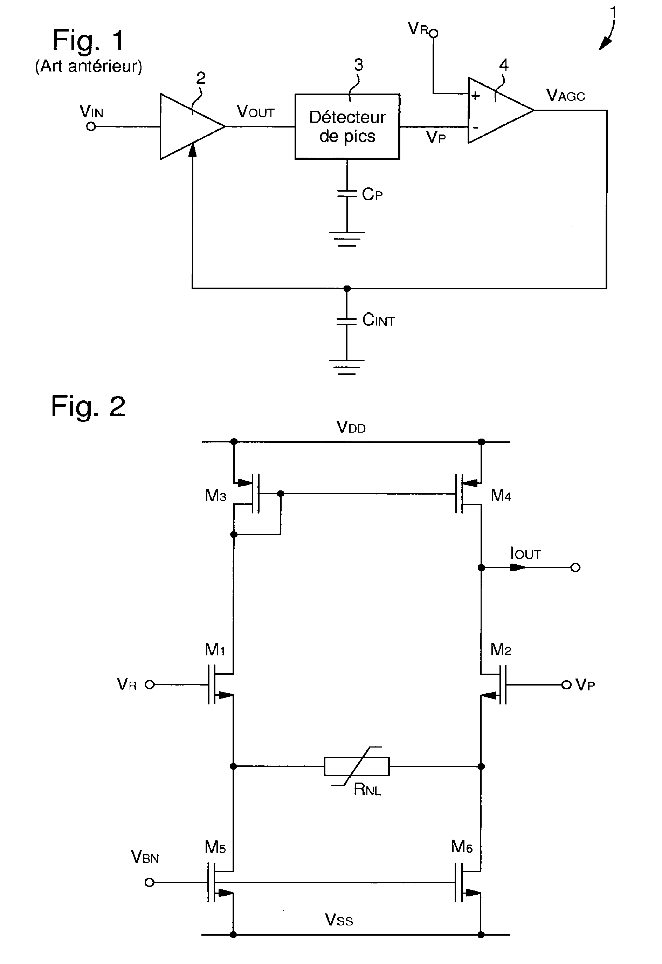

De manière conventionnelle notamment pour la réception de signaux de données ou de commande, un tel circuit électronique 1 peut comprendre les composants électroniques représentés à la figure 1 pour la commande du gain automatique d'un amplificateur d'entrée 2. Cet amplificateur d'entrée 2 est relié directement ou par l'intermédiaire d'un étage de mise en forme à une antenne de réception de signaux de données et/ou de commande non représentée. L'amplificateur d'entrée 2 permet d'amplifier selon un gain adapté dans la boucle de commande automatique du gain, un signal d'entrée V_{IN} sur la base du ou des signaux captés par l'antenne. Le signal de sortie V_{OUT}, qui est un signal alternatif, qui dépend de la fréquence porteuse des signaux captés, est fourni à un détecteur de pics conventionnels 3. Ce détecteur de pics 3 permet de fournir en sortie un signal redressé V_{P}, qui peut être continu et qui représente l'amplitude du signal d'entrée V_{IN} amplifié par l'amplificateur d'entrée 2. Ce signal redressé V_{P} peut être mémorisé sur un condensateur C_{P} du détecteur de pics 3.

Le circuit électronique 1 comprend encore un amplificateur-comparateur 4, qui détermine une erreur entre le signal redressé V_{P} représentatif de l'amplitude des signaux amplifiés V_{OUT} par l'amplificateur d'entrée 2, et un signal de référence V_{R}. Le signal redressé et le signal de référence sont généralement une tension redressée V_{P} et une tension de référence V_{R} fournies à l'entrée de l'amplificateur-comparateur 4. La tension redressée V_{P} est fournie à l'entrée négative, alors que la tension de référence V_{R} est fournie à l'entrée positive de l'amplificateur-comparateur 4. En fonction de l'erreur déterminée entre les deux tensions comparées, un signal d'adaptation sous la forme d'un courant ou d'une tension d'adaptation V_{AGC} est fourni par l'amplificateur-comparateur 4 à l'amplificateur d'entrée pour adapter le gain de cet amplificateur d'entrée 2. Un condensateur d'intégration C_{INT} est encore disposé en sortie de l'amplificateur-comparateur 4, si le signal de sortie de l'amplificateur-comparateur est sous la forme d'un courant. Cet amplificateur-comparateur 4 peut être défini comme un bloc à transconductance ou un amplificateur opérationnel à transconductance du type OTA. Le gain de cet amplificateur d'entrée 2 est adapté à une valeur de fonctionnement stable, jusqu'à ce que l'écart entre la tension redressée V_{P} et la tension de référence V_{R} devient proche de zéro.

Sans être représenté sur la figure 1, la sortie de l'amplificateur d'entrée 2 du circuit électronique peut être reliée à un bloc mélangeur. Ce bloc mélangeur permet de convertir la fréquence des signaux captés par l'antenne et amplifiés par l'amplificateur d'entrée au moyen d'au moins un signal oscillant d'un oscillateur local. Le ou les signaux intermédiaires fournis en sortie du bloc mélangeur peuvent ainsi être convertis à une basse fréquence, et même directement en bande de base avant une opération de démodulation des données ou commande dans un démodulateur. Pour pouvoir opérer correctement la démodulation des données, il est nécessaire d'adapter l'amplitude des signaux amplifiés par l'amplificateur d'entrée dans la boucle de commande automatique du gain.

Si l'écart entre l'amplitude attendue des signaux captés et l'amplitude d'un signal de référence est important, il est nécessaire d'avoir une adaptation rapide du gain de l'amplificateur d'entrée, afin de pouvoir effectuer notamment toutes les opérations de démodulation des données. Le temps d'établissement de la boucle de commande du gain automatique doit ainsi être diminué pour avoir rapidement un point de fonctionnement stable du circuit électronique.

On peut citer à ce titre la demande de brevet US 2009/0117868 A1, qui décrit un circuit électronique pour la commande automatique du gain d'un récepteur radio avec un rapide établissement d'adaptation du gain. Le circuit électronique comprend un amplificateur d'entrée, dont le gain peut être adapté. Cet amplificateur d'entrée reçoit des signaux captés par une antenne et filtrés et mis en forme par un étage de mise en forme. Le signal de sortie de l'amplificateur est relié à un démodulateur pour pouvoir déterminer les données des signaux captés par l'antenne. Le signal de sortie du démodulateur, qui peut être une tension de sortie, est comparé à un premier niveau de référence dans un premier comparateur et à un second niveau de référence dans un second comparateur. Le second niveau de référence est défini plus grand que le premier niveau de référence. La sortie de chaque comparateur est relié à une borne de commande du gain de l'amplificateur d'entrée.

Le premier comparateur fournit un premier courant de comparaison, qui est plus petit que le second courant de comparaison du second comparateur. Si la tension de sortie du démodulateur se trouve entre le premier niveau de seuil et le second niveau de seuil, un faible établissement du gain de l'amplificateur d'entrée est opéré. Par contre, si la tension de sortie du démodulateur se trouve au-dessus du second niveau de seuil, les deux courants des deux comparateurs s'additionnent de manière à opérer un rapide établissement du gain de l'amplificateur d'entrée. Ainsi une adaptation à double pente est effectuée dans la boucle de commande du gain automatique. Cependant un tel circuit électronique est de conception relativement compliquée de manière à réduire le temps d'établissement de la boucle de commande automatique du gain, ce qui constitue un inconvénient. De plus, il ne permet pas de tenir compte facilement d'une rapide adaptation du gain, quand la tension de sortie du démodulateur se trouve en dessous du premier niveau de seuil, ce qui constitue un autre inconvénient.

On peut citer encore la demande de brevet US 2004/0009758 A1, qui décrit un circuit électronique pour la commande automatique du gain à réponse rapide notamment pour des systèmes à bande étroite. Le circuit électronique comprend notamment un amplificateur d'entrée, dont le gain peut être adapté dans une boucle de commande automatique du gain. L'amplificateur d'entrée amplifie un signal d'entrée provenant de signaux captés par une antenne pour fournir un signal amplifié à un mélangeur pour une conversion à basse fréquence. Le mélangeur fournit des signaux en bande de base composés d'un signal en bande de base en phase I et d'un signal en bande de base en quadrature Q. Un détecteur de boucle AGC détermine un niveau de la somme des carrés des signaux en phase et en quadrature pour fournir un signal de sortie à un condensateur d'intégration. Ce condensateur d'intégration est relié par l'intermédiaire d'un dispositif d'entraînement à une borne de commande du gain de l'amplificateur d'entrée.

Lorsque la boucle de commande AGC est dans un état fermé, une adaptation de forme parabolique intervient pour adapter le gain de l'amplificateur d'entrée, ce qui permet de réduire le temps d'établissement de la boucle de commande automatique du gain, si le niveau détecté est grand par rapport au niveau désiré des signaux à capter. Cependant pour effectuer une telle adaptation dans la boucle de commande automatique du gain, beaucoup de composants électroniques relativement compliqués doivent être utilisés, ce qui constitue un inconvénient. De plus cela ne facilite pas le test électronique d'un tel circuit électronique, ce qui constitue un autre inconvénient.

### RESUME DE L'INVENTION

L'invention a donc pour but de pallier aux inconvénients de l'état de la technique susmentionné en fournissant un circuit électronique pour la commande automatique du gain d'au moins un amplificateur d'entrée, qui soit compact, facile à mettre en oeuvre et permettant d'adapter rapidement le gain de l'amplificateur par une adaptation à double pente.

A cet effet, l'invention concerne un circuit électronique pour la commande automatique du gain d'au moins un amplificateur d'entrée, qui comprend les caractéristiques définies dans la revendication indépendante 1.

Des formes particulières d'exécution du circuit électronique pour la commande automatique du gain d'au moins un amplificateur d'entrée sont définies dans les revendications dépendantes 2 à 11.

Un avantage du circuit électronique pour la commande automatique du gain d'au moins un amplificateur d'entrée réside dans le fait qu'il est très compact à pente double d'adaptation analogique du gain de l'amplificateur d'entrée, ce qui permet d'avoir un temps d'établissement très rapide. Lors de n'importe quelle transition du niveau du signal d'entrée, le gain dans la boucle de commande automatique du gain est dynamiquement et de manière analogique augmenté pour accélérer le temps d'attaque d'adaptation. Le gain de la boucle est par contre diminué vers un gain d'un fonctionnement stable du circuit électronique.

Pour effectuer cette adaptation à double pente dans la boucle, il est utilisé au moins un élément à transconductance du type analogique non-linéaire dans un amplificateur-comparateur non-linéaire. Cet élément à transconductance non-linéaire a une transconductance de faible valeur, quand l'écart des signaux en entrée de l'amplificateur-comparateur non-linéaire est en-dessous d'un seuil déterminé. Par contre, cet élément à transconductance non-linéaire a une transconductance de grande valeur, quand l'écart des signaux en entrée de l'amplificateur-comparateur non-linéaire est au-dessus du seuil déterminé, ce qui définit l'adaptation à double pente rapide et stable.

Avantageusement avec un amplificateur-comparateur non-linéaire pour l'adaptation à double pente du gain de l'amplificateur d'entrée, cela permet de réduire le temps d'attaque pour l'établissement rapide du gain dans la boucle de commande automatique du gain. Grâce à cela, il est possible également d'effectuer rapidement un test électronique d'un tel circuit électronique au terme du procédé de fabrication de circuits intégrés, même si le débit des données dans les signaux captés à traiter dans le circuit électronique est faible.

### BREVE DESCRIPTION DES FIGURES

Les buts, avantages et caractéristiques du circuit électronique pour la commande automatique du gain d'un amplificateur apparaîtront mieux dans la description suivante sur la base de formes d'exécution non limitatives illustrées par les dessins sur lesquels :
la figure 1 citée ci-devant représente de manière simplifiée les composants électroniques du circuit électronique pour la commande automatique du gain d'un amplificateur,
la figure 2 représente de manière simplifiée l'amplificateur-comparateur non-linéaire d'un signal d'erreur du circuit électronique pour la commande automatique du gain de l'amplificateur d'entrée selon l'invention,
la figure 3 représente une première forme d'exécution détaillée de l'amplificateur-comparateur non-linéaire d'un signal d'erreur du circuit électronique pour la commande automatique du gain de l'amplificateur d'entrée selon l'invention,
la figure 4 représente une seconde forme d'exécution détaillée de l'amplificateur-comparateur non-linéaire d'un signal d'erreur du circuit électronique pour la commande automatique du gain de l'amplificateur d'entrée selon l'invention,
la figure 5 représente une troisième forme d'exécution détaillée de l'amplificateur-comparateur non-linéaire d'un signal d'erreur du circuit électronique pour la commande automatique du gain de l'amplificateur d'entrée selon l'invention, et
la figure 6 représente un graphe du gain d'adaptation pour l'amplificateur d'entrée sur la base du signal d'erreur de l'amplificateur-comparateur non-linéaire du circuit électronique pour la commande automatique du gain de l'amplificateur d'entrée selon l'invention.

### DESCRIPTION DETAILLEE DE L'INVENTION

Dans la description suivante, tous les composants électroniques du circuit électronique pour la commande automatique du gain d'un amplificateur d'entrée, qui sont bien connus de l'homme du métier dans ce domaine technique ne seront relatés que de manière simplifiée. Le circuit électronique peut comprendre des composants similaires à ceux décrits en référence à la figure 1 citée ci-devant, mais avec un amplificateur-comparateur non-linéaire 4 susceptible d'adapter à double pente et de manière analogique le gain de l'amplificateur d'entrée 2 en fonction du signal d'erreur. Cet amplificateur d'entrée du type LNA ou VGA peut être apte à amplifier des signaux radiofréquences du type FSK ou PSK captés par une antenne ou d'autres types de signaux à bande étroite. Il peut s'agir également d'un amplificateur d'entrée disposé après un mélangeur de signaux pour amplifier des signaux intermédiaires à fréquence convertie.

La figure 2 représente donc de manière très générale un amplificateur-comparateur non-linéaire du circuit électronique pour la commande automatique du gain à double pente d'un amplificateur d'entrée. L'amplificateur-comparateur non-linéaire est composé de deux branches avec un agencement de transistors disposés en série entre une borne positive V_{DD} et une borne négative V_{SS} d'une source de tension d'alimentation non représentée. La tension d'alimentation du circuit électronique peut être définie de préférence entre 1.2 V et 3.6 V et dépend bien entendu de la technologie semi-conductrice utilisée, qui peut être une technologie bipolaire ou une technologie CMOS par exemple. Selon la technologie utilisée, la tension d'alimentation peut même être d'une valeur de l'ordre de 0.8 V.

Dans une première branche, l'amplificateur-comparateur non-linéaire comprend un premier transistor d'entrée M1 d'un premier type de conductivité. La grille ou la base de ce premier transistor d'entrée M1 définit une entrée positive pour recevoir un premier signal d'entrée positive V_{R}, qui est une tension de référence spécifique. Cette tension de référence V_{R} peut être programmée en fonction du niveau d'amplitude attendu du signal de sortie de l'amplificateur d'entrée.

La source ou l'émetteur du premier transistor d'entrée M1 est relié au drain ou au collecteur d'un premier transistor de polarisation M5 d'un premier type de conductivité, alors que le drain ou le collecteur du premier transistor d'entrée M1 est relié à un premier transistor monté en diode M3 d'un second type de conductivité d'un miroir de courant. La source ou l'émetteur du premier transistor de polarisation M5 est relié directement à une première borne de la source de tension d'alimentation, alors que la source ou l'émetteur du premier transistor M3 du miroir de courant est relié à une seconde borne de la source de tension d'alimentation. La grille ou la base du premier transistor de polarisation M5 est commandée par une tension de polarisation V_{B} pour que ce premier transistor de polarisation M5 agisse comme une première source de courant dans la première branche.

Dans une seconde branche, l'amplificateur-comparateur non-linéaire comprend un second transistor d'entrée M2 d'un premier type de conductivité. La grille ou la base de ce second transistor d'entrée M2 définit une entrée négative pour recevoir un second signal d'entrée négative V_{P}, qui dépend du niveau de la tension de sortie de l'amplificateur d'entrée du circuit électronique. Ce niveau de tension peut être fourni en sortie du détecteur de pics, qui détecte la tension maximale du signal de sortie alternatif de l'amplificateur d'entrée. Cette tension maximale correspond à une tension de crête. Ce niveau de tension peut être stocké sur un condensateur du détecteur de pics.

La source ou l'émetteur du second transistor d'entrée M2 est relié au drain ou au collecteur d'un second transistor de polarisation M6 d'un premier type de conductivité, alors que le drain ou le collecteur du second transistor d'entrée M2 est relié au drain ou au collecteur d'un second transistor M4 d'un second type de conductivité du miroir de courant. La source ou l'émetteur du second transistor de polarisation M6 est relié directement à une première borne de la source de tension d'alimentation, alors que la source ou l'émetteur du second transistor M4 du miroir de courant est relié à une seconde borne de la source de tension d'alimentation. La liaison du drain ou collecteur du second transistor d'entrée M2 avec le drain ou collecteur du second transistor M4 du miroir de courant définit la sortie de l'amplificateur-comparateur non-linéaire. Généralement le signal de sortie peut être un courant I_{OUT} ou une tension d'adaptation du gain à double pente de l'amplificateur d'entrée.

La grille ou la base du second transistor M4 du miroir de courant est reliée à la grille ou la base du premier transistor monté en diode M3 du miroir de courant de manière à miroiter le courant passant dans le premier transistor M3 dans le second transistor M4. De préférence, les premier et second transistors M3 et M4 du miroir de courant sont de même dimension pour que le courant dans le premier transistor M3 soit le même que le courant miroité dans le second transistor M4 dans un fonctionnement normal stable.

La grille ou la base du second transistor de polarisation M6 est directement reliée à la grille ou la base du premier transistor de polarisation M5, pour être commandée par la tension de polarisation V_{B}. Cette tension de polarisation V_{B} est définie pour que ce second transistor de polarisation M6 agisse comme une seconde source de courant dans la seconde branche. De préférence, les transistors de polarisation M5 et M6 sont de dimensions égales de telle manière que le courant de la première source de courant est égal au courant de la seconde source de courant.

Pour que l'amplificateur-comparateur non-linéaire fournisse un signal de sortie pour une adaptation analogique et dynamique du gain à double pente de l'amplificateur d'entrée, il comprend encore au moins un élément d'impédance à transconductance non-linéaire R_{NL}. Cet élément ou unité à transconductance non-linéaire relie les deux branches de l'amplificateur-comparateur non-linéaire. Généralement cet élément à transconductance non-linéaire R_{NL} relie la source ou l'émetteur du premier transistor d'entrée M1 à la source ou l'émetteur du second transistor d'entrée M2. Il est encore à noter que cet élément à transconductance non-linéaire est défini pour comprendre un ou plusieurs transistors, qui peuvent être combinés avec une ou plusieurs résistances.

Pour de petits écarts de tension entre la tension d'entrée positive V_{R} et la tension d'entrée négative V_{P}, la transconductance de cet élément est faible, ce qui correspond à une résistivité de grande valeur de manière à n'avoir qu'une très faible influence en liaison avec les deux branches. Le courant de sortie I_{OUT} ne varie donc que selon une pente faible. Par contre pour un écart de tension important au-delà d'un seuil défini, la transconductance de l'élément devient assez élevée, ce qui correspond à une résistivité de faible valeur avec une partie du courant d'une des branches passant à travers cet élément à transconductance non-linéaire. Le courant de sortie I_{OUT} varie dans ce cas selon une pente plus forte de manière à définir l'adaptation à double pente. Par exemple si la tension d'entrée négative V_{P} s'écarte de plus de 5 ou 10% de la tension de référence spécifique V_{R}, le seuil défini est dépassé et une grande transconductance de l'élément à transconductance non-linéaire est établie pour rapidement adapter le gain de l'amplificateur d'entrée.

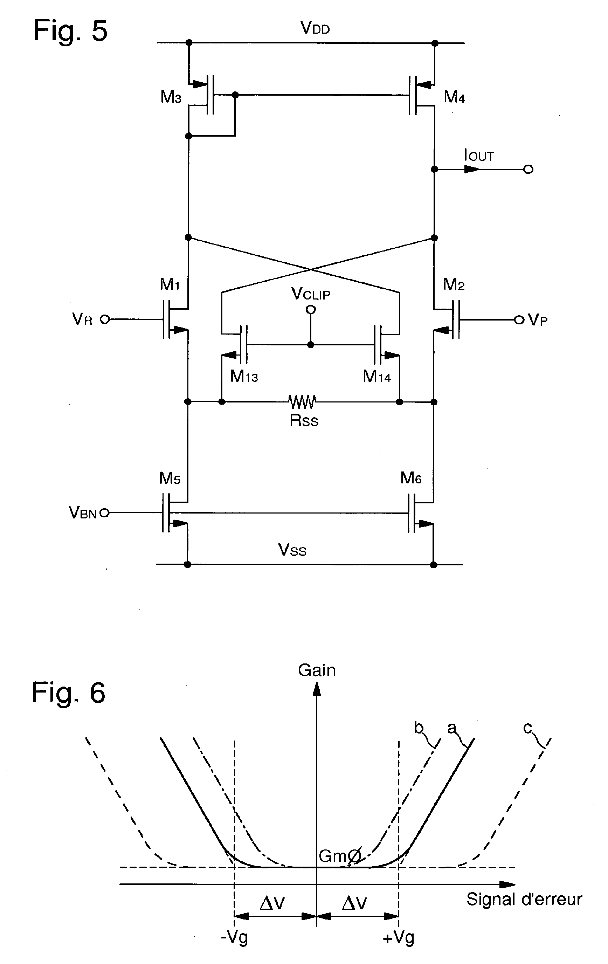

Sur la figure 6, il est représenté un graphe du gain à adapter pour l'amplificateur d'entrée par rapport au signal d'erreur, qui correspond à l'écart entre la tension d'entrée négative V_{P} et la tension de référence spécifique V_{R}. Dans une zone de faible écart en valeur absolue ΔV entre la tension d'entrée négative V_{P} et la tension de référence spécifique V_{R}, le gain de la boucle AGC est diminué ou augmenté lentement pour avoir un fonctionnement stable autour de la valeur attendue Gₘ₀. Par contre au-delà du seuil défini, un gain très fort ou très faible est imposé à l'amplificateur d'entrée pour rapidement revenir à un gain adapté à une valeur attendue de l'amplificateur d'entrée.

Comme représenté à la figure 2, les premier et second transistors d'entrée M1 et M2 peuvent être de préférence des transistors NMOS, tout comme les premier et second transistors de polarisation M5 et M6 reliés à la borne négative V_{SS} de la source de tension d'alimentation. Par contre les premier et second transistors M3 et M4 du miroir de courant peuvent être des transistors PMOS reliés à la borne positive V_{DD} de la source de tension d'alimentation. Pour le bon fonctionnement de l'amplificateur-comparateur non-linéaire, chaque signal d'entrée V_{P} et V_{R} de l'amplificateur-comparateur non-linéaire peut être à un niveau situé entre la tension de seuil du transistor NMOS, qu'il commande, et le potentiel haut V_{DD} de la source de tension d'alimentation.

Il est à noter qu'en lieu et place de l'agencement présenté à la figure 2, il peut être envisagé d'utiliser des transistors PMOS pour les transistors M1, M2, M5 et M6, et des transistors NMOS pour les transistors M3 et M4 dans une configuration inverse. Les transistors M5 et M6 sont ainsi reliés à la borne positive V_{DD}, alors que les transistors M3 et M4 sont reliés à la borne négative V_{SS}. De même une conception avec des transistors bipolaires peut être envisagée en remplaçant tous les transistors PMOS par des transistors PNP et tous les transistors NMOS par des transistors NPN. Une combinaison de transistors bipolaires et de transistors MOS peut aussi être envisagée pour l'amplificateur-comparateur non-linéaire, par exemple en ayant des transistors NPN ou PNP pour les transistors M1 et M2 et des transistors MOS pour les autres transistors M3 à M6.

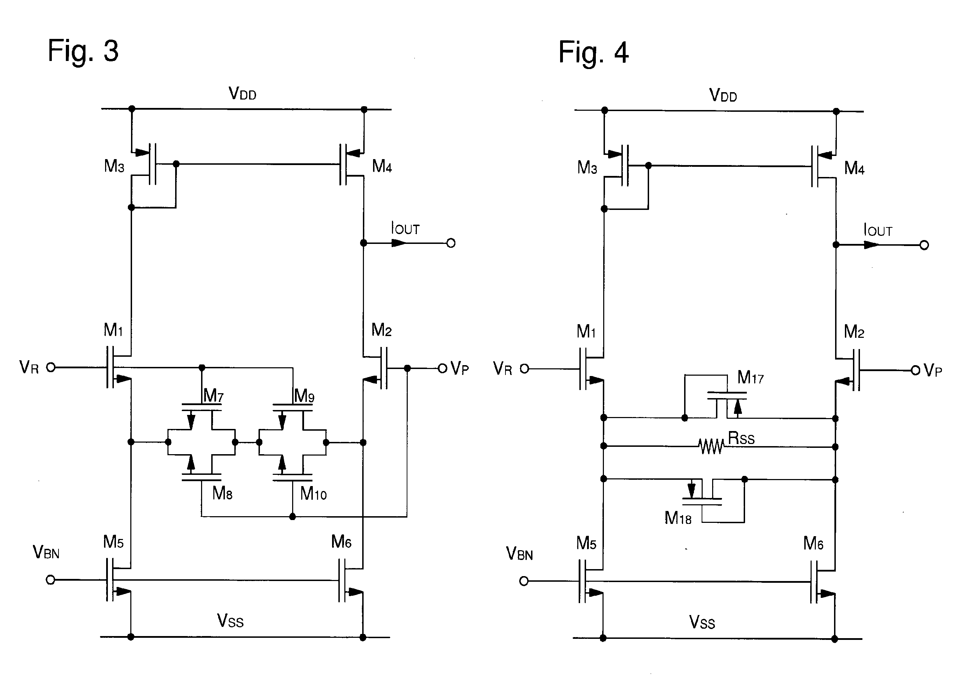

Une première forme de réalisation de l'élément à transconductance non-linéaire de l'amplificateur-comparateur non-linéaire est représentée à la figure 3. Il est à noter que les éléments de cette figure 3, qui correspondent à ceux de la figure 2 décrite ci-dessus, portent des signes de référence identiques. De ce fait par simplification, il ne sera pas répété la description de tous ces éléments.

L'élément à transconductance non-linéaire est composé de deux paires de transistors d'un premier type de conductivité M7, M8, M9 et M10 montées en série entre la source ou l'émetteur du premier transistor d'entrée M1 et la source ou l'émetteur du second transistor d'entrée M2. Les sources ou émetteurs des deux transistors M7 et M8 de la première paire sont reliées à la source ou l'émetteur du premier transistor d'entrée M1. Les drains ou collecteurs des deux transistors M7 et M8 de la première paire sont reliés aux sources ou émetteurs des deux transistors M9 et M10 de la seconde paire. Les drains ou collecteurs des deux transistors M9 et M10 de la seconde paire sont reliés à la source ou l'émetteur du second transistor d'entrée M2.

Les grilles ou bases d'un premier transistor M7 de la première paire et d'un premier transistor M9 de la seconde paire sont reliées à la grille ou la base du premier transistor d'entrée M1. Les grilles ou bases d'un second transistor M8 de la première paire et d'un second transistor M10 de la seconde paire sont reliées à la grille ou la base du second transistor d'entrée M2.

De préférence et comme représenté à la figure 3, les transistors des première et seconde paires de transistors de l'élément à transconductance non-linéaire, sont des transistors du type NMOS. Ces transistors NMOS M7 à M10 des paires de transistors sont reliés aux transistors d'entrée du type NMOS M1 et M2. Bien entendu comme expliqué en référence à la figure 2, les transistors de l'amplificateur-comparateur non-linéaire peuvent être d'un autre type que ceux représentés en figure 3. Il peut être envisagé de composer les deux paires de transistors avec des transistors du type PMOS, voire avec des transistors bipolaires du type PNP ou NPN. Comme expliqué ci-devant, la résistivité des paires de transistors est très grande, quand l'écart entre la tension redressée négative V_{P} et la tension de référence V_{R} est faible en dessous d'un seuil défini. Par contre, la résistivité de ces paires de transistors devient faible, quand l'écart entre la tension redressée négative V_{P} et la tension de référence V_{R} est au-dessus du seuil défini.

La forme d'exécution présentée sur cette figure 3 se base sur une architecture à dégénérescence de source, qui est bien connue. La dimension des transistors NMOS M7 à M10 peut être choisie de telle manière que la résistivité exposée est beaucoup plus grande que la transconductance des transistors d'entrée M1 et M2. Grâce à cette propriété, la caractéristique de transfert est similaire à ce qui est requis pour avoir une boucle de commande automatique du gain non-linéaire comme représenté sur la figure 6. Pour pouvoir ajuster la transconductance, il est possible de soit augmenter le nombre de transistors des paires de transistors ou augmenter leur longueur. Il doit être tenu compte en fonction de la technologie utilisée de l'amélioration de la performance de linéarité, ce qui fait que la résistivité des transistors M7 à M10 à besoin d'être choisie très prudemment et assez proche de la transconductance des transistors d'entrée M1 et M2.

A titre d'exemple non limitatif, pour une transconductance Gm des transistors d'entrée M1 et M2, la résistivité équivalente totale de l'élément à transconductance non-linéaire doit être plus grande que 1/Gm. Ainsi les transistors d'entrée M1 et M2 peuvent être réalisés avec une longueur de grille égale à 0.35 µm et une largeur de grille égale à 10 µm, alors que pour chaque transistor des paires de transistors M7 à M10, la longueur de grille peut être égale à 0.35 µm et la largeur de grille peut être égale à 1 µm.

Une seconde forme de réalisation de l'élément à transconductance non-linéaire de l'amplificateur-comparateur non-linéaire est représentée à la figure 4. Il est à noter que les éléments de cette figure 4, qui correspondent à ceux des figures 2 et 3 décrites ci-dessus, portent des signes de référence identiques. De ce fait par simplification, il ne sera pas répété la description de tous ces éléments.

L'élément à transconductance non-linéaire est composé de deux transistors montés en diode M17 et M18 d'un second type de conductivité et d'une résistance R_{SS} montés tous en parallèle et connectés aux sources ou émetteurs des transistors d'entrée M1 et M2. La source ou l'émetteur du premier transistor monté en diode M17 est relié à la source ou l'émetteur du second transistor d'entrée M2, alors que la grille ou la base et le drain ou le collecteur du premier transistor monté en diode M17 sont reliés à la source ou l'émetteur du premier transistor d'entrée M1. La source ou l'émetteur du second transistor monté en diode M18 est relié à la source ou l'émetteur du premier transistor d'entrée M1, alors que la grille ou la base et le drain ou le collecteur du second transistor monté en diode M18 sont reliés à la source ou l'émetteur du second transistor d'entrée M2. Le premier transistor monté en diode M17 est monté inversement au second transistor monté en diode M18.

A titre d'exemple non limitatif, la résistance R_{SS} peut avoir une valeur résistive égale à 1 MOhms ou 10 MOhms ou supérieure, et les deux transistors montés en diode M17 et M18, qui sont de préférence des transistors du type PMOS comme représenté à la figure 4, peuvent être dimensionnés comme les transistors NMOS des paires de transistors M7 à M10 représentés à la figure 3. La valeur résistive de la résistance R_{SS} est choisie beaucoup plus grande que la résistance de source équivalente des transistors d'entrée M1 et M2. Grâce à cette grande valeur de résistance Rss, il est possible de définir la zone à gain faible de l'amplificateur-comparateur non-linéaire comme représenté sur la figure 6 autour du gain attendu Gₘ₀ de l'amplificateur d'entrée.

Lorsque la différence entre la tension d'entrée négative V_{P} et la tension d'entrée positive V_{R} est plus grande qu'un écart déterminé, qui est un seuil d'erreur défini, les transistors montés en diode M17 et M18 seront actifs et réduiront la résistivité équivalente des sources ou émetteurs des transistors d'entrée M1 et M2. Par contre, quand la tension d'entrée négative V_{P} est proche de la tension d'entrée positive V_{R}, les transistors montés en diode M17 et M18 sont non conducteurs, et la transconductance Gm est égale à 1/R_{SS}. Il est ainsi possible d'atteindre une transconductance non-linéaire comme requis et représenté sur le graphe de la figure 6, tout en gardant une bonne stabilité, lorsque les tensions d'entrée sont relativement proches l'une de l'autre.

Une troisième forme de réalisation de l'élément à transconductance non-linéaire de l'amplificateur-comparateur non-linéaire est représentée à la figure 5. Il est à noter que les éléments de cette figure 5, qui correspondent à ceux des figures 2 à 4 décrites ci-dessus, portent des signes de référence identiques. De ce fait par simplification, il ne sera pas répété la description de tous ces éléments.

L'élément à transconductance non-linéaire est composé d'une résistance R_{SS} connectée aux sources ou émetteurs des transistors d'entrée M1 et M2, d'un premier transistor d'adaptation M13 d'un premier type de conductivité et d'un second transistor d'adaptation M14 d'un premier type de conductivité. La source ou l'émetteur du premier transistor M13 est relié à la source ou l'émetteur du premier transistor d'entrée M1, alors que le drain ou le collecteur du premier transistor M13 est relié au drain ou au collecteur du second transistor d'entrée M2. La source ou l'émetteur du second transistor M14 est relié à la source ou l'émetteur du second transistor d'entrée M2, alors que le drain ou le collecteur du second transistor M14 est relié au drain ou au collecteur du premier transistor d'entrée M1.

Les grilles ou les bases des premier et second transistors M13 et M14 de l'élément à transconductance non-linéaire, sont reliées l'une à l'autre afin de recevoir une tension V_{CLIP} d'adaptation de seuil de la transconductance de l'élément à transconductance non-linéaire. L'erreur admise entre les deux tensions d'entrée pour être dans une zone d'adaptation lente autour de la valeur attendue du gain de l'amplificateur d'entrée, peut être définie en fonction de la valeur de la tension V_{CLIP} appliquée sur les grilles ou bases des premier et second transistors M13 et M14. Bien entendu, la valeur de cette tension V_{CLIP} est également dépendante de la technologie utilisée et de la température de fonctionnement.

Comme représenté à la figure 5, les premier et second transistors M13 et M14 de l'élément à transconductance non-linéaire, sont de préférence des transistors du type NMOS, tout comme les transistors d'entrée M1 et M2 et les transistors de polarisation M5 et M6 reliés à la borne négative Vss de la source de tension d'alimentation. Par contre, les transistors du miroir de courant M3 et M4 sont des transistors du type PMOS reliés à la borne positive V_{DD} de la source de tension d'alimentation. Comme pour la seconde forme d'exécution de la figure 4, la résistance Rss peut être définie avec une grande valeur résistive, par exemple à 1 MOhms, ou 10 MOhms ou supérieure. Cette résistance R_{SS} peut définir la transconductance attendue 1/Gₘ₀. Ceci permet de définir une zone à faible gain, quand la différence entre les tensions d'entrée V_{P} et V_{R} est relativement faible. Par contre, quand la différence des tensions d'entrée est plus grande que +V_{CLIP} ou plus faible que -V_{CLIP}, les premier et second transistors M13 et M14 sont actifs. Dans ces conditions, le courant passe exclusivement par l'un ou l'autre des premier et second transistors M13 et M14 en fonction de la différence positive ou négative des tensions d'entrée. La transconductance va donc augmenter fortement pour définir les deux pentes représentées sur la figure 6.

La figure 6 représente donc un graphe du gain d'adaptation pour l'amplificateur d'entrée sur la base du signal d'erreur de l'amplificateur-comparateur non-linéaire du circuit électronique. Ce graphe du gain d'adaptation est similaire pour une configuration du type NMOS ou du type PMOS de l'amplificateur-comparateur non-linéaire. L'adaptation automatique du gain présente au moins deux pentes.

Si l'écart en valeur absolue ΔV entre les tensions d'entrée est au-delà d'un seuil défini dans une zone d'erreur entre -Vg et +Vg, un gain très fort ou très faible est appliqué à l'amplificateur d'entrée par l'amplificateur-comparateur non-linéaire pour revenir rapidement à une valeur de gain attendue de l'amplificateur d'entrée. Si la tension à l'entrée négative est plus faible que la tension à l'entrée positive dans l'amplificateur-comparateur non-linéaire, cela signifie que le gain n'est pas suffisant. Dans ces conditions, l'amplificateur-comparateur non-linéaire force un gain plus important dans l'amplificateur d'entrée. Par contre, si la tension à l'entrée positive est plus faible que la tension à l'entrée négative dans l'amplificateur-comparateur non-linéaire, le gain est trop élevé. Dans ces conditions, l'amplificateur-comparateur non-linéaire réduit le gain dans l'amplificateur d'entrée.

Il est représenté trois courbes de gain a, b et c sur cette figure 6, qui dépendent de la valeur de tension V_{CLIP} appliquée sur les premier et second transistors M13 et M14 de la figure 5. Plus cette tension V_{CLIP} est faible et plus la pente forte d'adaptation du gain survient à une différence de tensions d'entrée faible comme montré par la courbe b. Plus cette tension V_{CLIP} est forte et plus la pente forte d'adaptation du gain survient à une différence de tensions d'entrée grande comme montré par la courbe c. Cette tension V_{CLIP} peut être changée lors du fonctionnement du circuit électronique pour adapter les tensions -Vg et +Vg de la zone d'erreur ou également la marge de bruit.

A partir de la description qui vient d'être faite, plusieurs variantes du circuit électronique pour la commande automatique du gain d'un amplificateur d'entrée peuvent être conçues par l'homme du métier sans sortir du cadre de l'invention définie par les revendications. Le premier signal de référence peut également être fourni à la grille ou base du second transistor d'entrée de l'amplificateur-comparateur, alors que le second signal dépendant du niveau du signal de sortie de l'amplificateur d'entrée, peut être fourni au premier transistor d'entrée. Dans ces conditions, il peut encore être monté en inverseur en sortie de l'amplificateur-comparateur ou commander l'augmentation du gain, si le premier signal est supérieur au second signal. Il peut être envisagé de relier des résistances en série dans chaque branche de l'amplificateur-comparateur non-linéaire, ou pour linéariser les transistors du miroir de courant ou les transistors de polarisation.

## Revendications

1. Circuit électronique (1) pour la commande automatique du gain d'un amplificateur d'entrée (2), le circuit électronique comprenant une boucle de commande automatique du gain avec un amplificateur-comparateur non-linéaire (4) pour comparer un premier signal de référence (V_{R}) avec un second signal (V_{P}) relatif au niveau d'amplitude d'un signal de sortie de l'amplificateur d'entrée, l'amplificateur-comparateur non-linéaire (4) permettant d'adapter à double pente dynamiquement et de manière analogique le gain de l'amplificateur d'entrée,
**caractérisé en ce que** l'amplificateur-comparateur non-linéaire (4) comprend une première branche avec un premier transistor d'entrée (M1) d'un premier type de conductivité, disposé en série entre un premier transistor de polarisation (M5) du premier type de conductivité et un premier transistor monté en diode (M3) d'un second type de conductivité d'un miroir de courant, entre une borne négative (Vss) et une borne positive (V_{DD}) d'une source de tension d'alimentation, une grille ou une base du premier transistor d'entrée (M1) étant apte à recevoir le premier signal (V_{R}) ou le second signal (V_{P}),
**en ce que** l'amplificateur-comparateur non-linéaire (4) comprend une seconde branche avec un second transistor d'entrée (M2) du premier type de conductivité, disposé en série entre un second transistor de polarisation (M6) du premier type de conductivité et un second transistor (M4) du second type de conductivité du miroir de courant, entre la borne négative (V_{SS}) et la borne positive (V_{DD}) de la source de tension d'alimentation, une grille ou une base du second transistor de polarisation (M6) étant reliée à une grille ou une base du premier transistor de polarisation (M5) pour être alimentée par une tension de polarisation (V_{B}), une grille ou une base du second transistor (M4) du miroir de courant étant reliée à une grille ou une base du premier transistor monté en diode (M3) du miroir de courant, et une grille ou une base du second transistor d'entrée (M2) étant apte à recevoir le second signal de référence (V_{P}) ou le premier signal (V_{R}) inversement au premier transistor d'entrée (M1), et
**en ce que** l'amplificateur-comparateur non-linéaire (4) comprend au moins un élément à transconductance non-linéaire (R_{NL}) reliant la source ou l'émetteur du premier transistor d'entrée (M1) à la source ou l'émetteur du second transistor d'entrée (M2) et apte à permettre à l'amplificateur-comparateur de fournir par le drain ou le collecteur du second transistor d'entrée (M2), un signal (I_{OUT}) d'ajustement du gain à double pente, si l'écart entre le premier signal d'entrée (V_{R}) et le second signal d'entrée (V_{P}) est plus grand ou plus petit qu'un seuil défini.

2. Circuit électronique (1) selon la revendication 1, **caractérisé en ce que** les premier et second transistors d'entrée (M1, M2) sont des transistors du type NMOS, **en ce que** les premier et second transistors de polarisation (M5, M6) sont des transistors du type NMOS, et **en ce que** les premier et second transistors (M3, M4) du miroir de courant sont des transistors du type PMOS.

3. Circuit électronique (1) selon la revendication 2, **caractérisé en ce que** les premier et second transistors de polarisation ont leur source reliée directement à la borne négative (V_{SS}) de la source de tension d'alimentation, et **en ce que** les premier et second transistors (M3, M4) du miroir de courant ont leur source reliée directement à la borne positive (V_{DD}) de la source de tension d'alimentation.

4. Circuit électronique (1) selon la revendication 1, **caractérisé en ce que** les premier et second transistors d'entrée (M1, M2) sont des transistors du type PMOS, **en ce que** les premier et second transistors de polarisation (M5, M6) sont des transistors du type PMOS, et **en ce que** les premier et second transistors (M3, M4) du miroir de courant sont des transistors du type NMOS.

5. Circuit électronique (1) selon la revendication 4, **caractérisé en ce que** les premier et second transistors de polarisation ont leur source reliée directement à la borne positive (V_{DD}) de la source de tension d'alimentation, et **en ce que** les premier et second transistors (M3, M4) du miroir de courant ont leur source reliée directement à la borne négative (V_{SS}) de la source de tension d'alimentation.

6. Circuit électronique (1) selon la revendication 1, **caractérisé en ce que** l'élément à transconductance non-linéaire est composé de deux paires de transistors (M7, M8, M9, M10) d'un même type de conductivité, montées en série entre la source ou l'émetteur du premier transistor d'entrée (M1) et la source ou l'émetteur du second transistor d'entrée (M2).

7. Circuit électronique (1) selon la revendication 6, **caractérisé en ce que** les deux paires de transistors (M7, M8, M9, M10) sont composées de transistors du type NMOS, **en ce que** les sources des deux transistors (M7, M8) de la première paire de transistors sont reliées à la source ou l'émetteur du premier transistor d'entrée (M1), **en ce que** les drains des deux transistors (M7, M8) de la première paire de transistors sont reliés aux sources des deux transistors (M9, M10) de la seconde paire de transistors, **en ce que** les drains des deux transistors (M9, M10) de la seconde paire de transistors sont reliés à la source ou l'émetteur du second transistor d'entrée (M2), **en ce que** les grilles d'un premier transistor (M7) de la première paire de transistors et d'un premier transistor (M9) de la seconde paire de transistors sont reliées à la grille ou la base du premier transistor d'entrée (M1), et **en ce que** les grilles d'un second transistor (M8) de la première paire de transistors et d'un second transistor (M10) de la seconde paire de transistors sont reliées à la grille ou la base du second transistor d'entrée (M2).

8. Circuit électronique (1) selon la revendication 1, **caractérisé en ce que** l'élément à transconductance non-linéaire est composé d'un premier transistor monté en diode (M17), d'un second transistor monté en diode (M18) de manière inverse au premier transistor monté en diode (M17), et d'une résistance R_{SS}, qui sont montés tous en parallèle et connectés aux sources ou émetteurs des premier et second transistors d'entrée (M1, M2).

9. Circuit électronique (1) selon la revendication 8, **caractérisé en ce que** les premier et second transistors montés en diode (M17, M18) sont des transistors du type PMOS, **en ce que** la source du premier transistor monté en diode (M17) est reliée à la source ou l'émetteur du second transistor d'entrée (M2), **en ce que** la grille et le drain du premier transistor monté en diode (M17) sont reliés à la source ou l'émetteur du premier transistor d'entrée (M1), **en ce que** la source du second transistor monté en diode (M18) est reliée à la source ou l'émetteur du premier transistor d'entrée (M1), et **en ce que** la grille et le drain du second transistor monté en diode (M18) sont reliés à la source ou l'émetteur du second transistor d'entrée (M2).

10. Circuit électronique (1) selon la revendication 1, **caractérisé en ce que** l'élément à transconductance non-linéaire est composé d'une résistance (R_{SS}) connectée aux sources ou émetteurs des premier et second transistors d'entrée (M1, M2), d'un premier transistor d'adaptation (M13) d'un premier type de conductivité et d'un second transistor d'adaptation (M14) d'un premier type de conductivité, **en ce que** la source ou l'émetteur du premier transistor d'adaptation (M13) est relié à la source ou l'émetteur du premier transistor d'entrée (M1), **en ce que** le drain ou le collecteur du premier transistor d'adaptation (M13) est relié au drain ou au collecteur du second transistor d'entrée (M2), **en ce que** la source ou l'émetteur du second transistor d'adaptation (M14) est relié à la source ou l'émetteur du second transistor d'entrée (M2), **en ce que** le drain ou le collecteur du second transistor d'adaptation (M14) est relié au drain ou au collecteur du premier transistor d'entrée (M1), et **en ce que** les grilles ou les bases des premier et second transistors d'adaptation (M13, M14) sont reliées l'une à l'autre pour recevoir une tension d'adaptation (V_{CLIP}) de manière à adapter le seuil d'adaptation du gain à double pente de l'amplificateur-comparateur non-linéaire (4).

11. Circuit électronique (1) selon l'une des revendications 1 et 10, **caractérisé en ce que** le seuil défini de l'amplificateur-comparateur non-linéaire (4) pour l'adaptation du gain est établi en fonction d'un écart entre le premier signal de référence (V_{R}), qui est une tension de référence, et le second signal de référence (V_{P}), qui est une tension de crête fournie à la sortie d'un détecteur de pics (3), qui est relié à la sortie de l'amplificateur d'entrée (2), si la tension de crête (V_{P}) s'écarte de plus de 5 ou 10% de la tension de référence (V_{R}), le seuil défini est dépassé pour une adaptation du gain à forte pente, alors que pour un écart en tension en dessous du seuil défini, l'adaptation du gain est effectuée à faible pente.

## Patentansprüche

1. Elektronische Schaltung (1) für die automatische Steuerung der Verstärkung eines Eingangsverstärkers (2), wobei die elektronische Schaltung eine Schleife für die automatische Steuerung der Verstärkung mit einem nichtlinearen Verstärker-Komparator (4) umfasst, um ein erstes Referenzsignal (V_{R}) mit einem zweiten Signal (V_{P}), das auf den Amplitudenpegel eines Ausgangssignals des Eingangsverstärkers bezogen ist, zu vergleichen, wobei der nichtlineare Verstärker-Komparator (4) ermöglicht, die Verstärkung des Eingangsverstärkers mit doppelter Steigung dynamisch und auf analoge Weise anzupassen,
**dadurch gekennzeichnet, dass** der nichtlineare Verstärker-Komparator (4) einen ersten Zweig umfasst, mit einem ersten Eingangstransistor (M1) eines ersten Leitfähigkeitstyps, der zwischen einen ersten Vorspannungstransistor (M5) des ersten Leitfähigkeitstyps und einen ersten als Diode geschalteten Transistor (M3) eines zweiten Leitfähigkeitstyps eines Stromspiegels zwischen einem negativen Anschluss (V_{SS}) und einem positiven Anschluss (V_{DD}) einer Versorgungsspannungsquelle in Serie geschaltet ist, wobei ein Gate oder eine Basis des ersten Eingangstransistors (M1) das erste Signal (V_{R}) oder das zweite Signal (V_{P}) empfangen kann,
dass der nichtlineare Verstärker-Komparator (4) einen zweiten Zweig umfasst, mit einem zweiten Eingangstransistor (M2) des ersten Leitfähigkeitstyps, der zwischen einen zweiten Vorspannungstransistor (M6) des ersten Leitfähigkeitstyps und einen zweiten Transistor (M4) des zweiten Leitfähigkeitstyps des Stromspiegels zwischen dem negativen Anschluss (V_{SS}) und dem positiven Anschluss (V_{DD}) der Versorgungsspannungsquelle in Serie geschaltet ist, wobei ein Gate oder eine Basis des zweiten Vorspannungstransistors (M6) mit einem Gate oder einer Basis des ersten Vorspannungstransistors (M5) verbunden ist, um durch die Vorspannung (V_{B}) versorgt zu werden, wobei ein Gate oder eine Basis des zweiten Transistors (M4) des Stromspiegels mit einem Gate oder einer Basis des ersten als Diode geschalteten Transistors (M3) des Stromspiegels verbunden ist und ein Gate oder eine Basis des zweiten Eingangstransistors (M2) das zweite Referenzsignal (V_{P}) oder das erste Signal (V_{R}) invers zu dem ersten Eingangstransistor (M1) empfangen kann, und
dass der nichtlineare Verstärker-Komparator (4) wenigstens ein Element (RNL) mit nichtlinearer Transkonduktanz umfasst, das die Source oder den Emitter des ersten Eingangstransistors (M1) mit der Source oder dem Emitter des zweiten Eingangstransistors (M2) verbindet und an den Verstärker-Komparator über den Drain oder den Kollektor des zweiten Eingangstransistors (M2) ein Signal (I_{OUT}) zum Einstellen der Verstärkung mit doppelter Steigung liefern kann, falls der Abstand zwischen dem ersten Eingangssignal (V_{R}) und dem zweiten Eingangssignal (V_{P}) größer oder kleiner als ein definierter Schwellenwert ist.

2. Elektronische Schaltung (1) nach Anspruch 1, **dadurch gekennzeichnet, dass** der erste und der zweite Eingangstransistor (M1, M2) Transistoren des NMOS-Typs sind, dass der erste und der zweite Vorspannungstransistor (M5, M6) Transistoren des NMOS-Typs sind und dass der erste und der zweite Transistor (M3, M4) des Stromspiegels Transistoren des PMOS-Typs sind.

3. Elektronische Schaltung (1) nach Anspruch 2, **dadurch gekennzeichnet, dass** der erste und der zweite Vorspannungstransistor mit ihrer Source direkt mit dem negativen Anschluss (V_{SS}) der Versorgungsspannungsquelle verbunden sind und dass der erste und der zweite Transistor (M3, M4) des Stromspiegels mit ihrer Source direkt mit dem positiven Anschluss (V_{DD}) der Versorgungsspannungsquelle verbunden sind.

4. Elektronische Schaltung (1) nach Anspruch 1, **dadurch gekennzeichnet, dass** der erste und der zweite Eingangstransistor (M1, M2) Transistoren vom PMOS-Typ sind, dass der erste und der zweite Vorspannungstransistor (M5, M6) Transistoren vom PMOS-Typ sind und dass der erste und der zweite Transistor (M3, M4) des Stromspiegels Transistoren vom NMOS-Typ sind.

5. Elektronische Schaltung (1) nach Anspruch 4, **dadurch gekennzeichnet, dass** der erste und der zweite Vorspannungstransistor mit ihrer Source direkt mit dem positiven Anschluss (V_{DD}) der Versorgungsspannungsquelle verbunden sind und dass der erste und der zweite Transistor (M3, M4) des Stromspiegels mit ihrer Source direkt mit dem negativen Anschluss (V_{SS}) der Versorgungs-spannungsquelle verbunden sind.

6. Elektronische Schaltung (1) nach Anspruch 1, **dadurch gekennzeichnet, dass** das Element mit nichtlinearer Transkonduktanz aus zwei Paaren von Transistoren (M7, M8, M9, M10) desselben Leitfähigkeitstyps aufgebaut ist, die zwischen der Source oder dem Emitter des ersten Eingangstransistors (M1) und der Source oder dem Emitter des zweiten Eingangstransistors (M2) in Serie geschaltet sind.

7. Elektronische Schaltung (1) nach Anspruch 6, **dadurch gekennzeichnet, dass** die zwei Paare von Transistoren (M7, M8, M9, M10) aus Transistoren des NMOS-Typs zusammengesetzt sind, dass die Sources der zwei Transistoren (M7, M8) des ersten Paars von Transistoren mit der Source oder dem Emitter des ersten Eingangstransistors (M1) verbunden sind, dass die Drains der zweiten Transistoren (M7, M8) des ersten Paars von Transistoren mit den Sources der zwei Transistoren (M9, M10) des zweiten Paars von Transistoren verbunden sind, dass die Drains der zwei Transistoren (M9, M10) des zweiten Paars von Transistoren mit der Source oder dem Emitter des zweiten Eingangstransistors (M2) verbunden sind, dass die Gates eines ersten Transistors (M7) des ersten Paars von Transistoren und eines ersten Transistors (M9) des zweiten Paars von Transistoren mit dem Gate oder der Basis des ersten Eingangstransistors (M1) verbunden sind und dass die Gates eines zweiten Transistors (M8) des ersten Paars von Transistoren und eines zweiten Transistors (M10) des zweiten Paars von Transistoren mit dem Gate oder der Basis des zweiten Eingangstransistors (M2) verbunden sind.

8. Elektronische Schaltung (1) nach Anspruch 1, **dadurch gekennzeichnet, dass** das Element mit nichtlinearer Transkonduktanz aus einem ersten als Diode geschalteten Transistor (M17), einem zweiten invers zu dem ersten als Diode geschalteten Transistor (M17) als Diode geschalteten Transistor (M18) und einem Widerstand (R_{SS}), die alle parallel geschaltet und mit den Sources oder Emittern des ersten und des zweiten Eingangstransistors (M1, M2) verbunden sind, gebildet ist.

9. Elektronische Schaltung (1) nach Anspruch 8, **dadurch gekennzeichnet, dass** der erste und der zweite als Diode geschaltete Transistor (M17, M18) Transistoren des PMOS-Typs sind, dass die Source des ersten als Diode geschalteten Transistors (M17) mit der Source oder dem Emitter des zweiten Eingangstransistors (M2) verbunden ist, dass das Gate und der Drain des ersten als Diode geschalteten Transistors (M17) mit der Source oder dem Emitter des ersten Eingangstransistors (M1) verbunden sind, dass die Source des zweiten als Diode geschalteten Transistors (M18) mit der Source oder dem Emitter des ersten Eingangstransistors (M1) verbunden ist und dass das Gate und der Drain des zweiten als Diode geschalteten Transistors (M18) mit der Source oder dem Emitter des zweiten Eingangstransistors (M2) verbunden sind.

10. Elektronische Schaltung (1) nach Anspruch 1, **dadurch gekennzeichnet, dass** das Element mit nichtlinearer Transkonduktanz aus einem Widerstand (R_{SS}), der mit den Sources oder Emittern des ersten und des zweiten Eingangstransistors (M1, M2) verbunden ist, einem ersten Anpassungstransistor (M13) eines ersten Leitfähigkeitstyps und einem zweiten Anpassungstransistor (M14) eines ersten Leitfähigkeitstyps gebildet ist, dass die Source oder der Emitter des ersten Anpassungstransistors (M13) mit der Source oder dem Emitter des ersten Eingangstransistors (M1) verbunden ist, dass der Drain oder der Kollektor des ersten Anpassungstransistors (M13) mit dem Drain oder dem Kollektor des zweiten Eingangstransistors (M2) verbunden ist, dass die Source oder der Emitter des zweiten Anpassungstransistors (M14) mit der Source oder dem Emitter des zweiten Eingangstransistors (M2) verbunden ist, dass der Drain oder der Kollektor des zweiten Anpassungstransistors (M14) mit dem Drain oder dem Kollektor des ersten Eingangstransistors (M1) verbunden ist und dass die Gates oder die Basen des ersten und des zweiten Anpassungstransistors (M13, M14) miteinander verbunden sind, um eine Anpassungsspannung (V_{CLIP}) zu empfangen, derart, dass der Anpassungsschwellenwert der Verstärkung mit doppelter Steigung des nichtlinearen Verstärker-Komparators (4) angepasst wird.

11. Elektronische Schaltung (1) nach einem der Ansprüche 1 und 10, **dadurch gekennzeichnet, dass** der definierte Schwellenwert des nichtlinearen Verstärker-Komparators (4) für die Anpassung der Verstärkung als Funktion eines Abstands zwischen dem ersten Referenzsignal (V_{R}), das eine Referenzspannung ist, und dem zweiten Referenzsignal (V_{P}), das eine an den Ausgang eines Spitzendetektors (3) gelieferte Spitzenspannung ist, gebildet wird, wobei der Spitzendetektor (3) mit dem Ausgang des Eingangsverstärkers (2) verbunden ist, falls die Spitzenspannung (V_{P}) um mehr als 5 oder 10 % von der Referenz-spannung (V_{R}) abweicht, wobei der definierte Schwellenwert für eine Anpassung der Verstärkung mit starker Steigung überschritten wird, während bei einer Spannungsabweichung unterhalb des definierten Schwellenwerts die Anpassung der Verstärkung mit geringer Steigung vorgenommen wird.

## Claims

1. Electronic circuit (1) for the automatic gain control of an input amplifier (2), the electronic circuit including an automatic gain control loop with a non-linear amplifier-comparator (4), for comparing a first reference signal (V_{R}) to a second signal (V_{P}) relating to the amplitude level of an output signal of the input amplifier, the non-linear amplifier-comparator (4) allowing the dynamic, analogue, dual slope adaptation of the input amplifier gain,
**characterized in that** the non-linear amplifier-comparator (4) includes a first branch with a first input transistor (M1) having a first type of conductivity, arranged in series between a first polarisation transistor (M5) of the first type of conductivity and a first diode-connected transistor (M3) having a second type of conductivity of a current mirror, between a negative terminal (V_{SS}) and a positive terminal (V_{DD}) of a supply voltage source, a gate or a base of the first input transistor (M1) being capable of receiving the first signal (V_{R}) or the second signal (V_{P}),
**in that** the non-linear amplifier-comparator (4) includes a second branch with a second input transistor (M2) of the first type of conductivity, arranged in series between a second polarisation transistor (M6) of the first type of conductivity and a second transistor (M4) of the second type of conductivity of the current mirror, between the negative terminal (V_{SS}) and the positive terminal (V_{DD}) of the supply voltage source, a gate or a base of the second polarisation transistor (M6) being connected to a gate or a base of the first polarisation transistor (M5) to be powered by a polarisation voltage (V_{B}), a gate or a base of the second transistor (M4) of the current mirror being connected to a gate or a base of the first diode-connected transistor (M3) of the current mirror, and a gate or a base of the second input transistor (M2) being capable of receiving the second reference signal (V_{P}) or the first signal (V_{R}) inversely to the first input transistor (M1), and
**in that** the non-linear amplifier-comparator (4) includes at least one non-linear transconductance element (R_{NL}) connecting the source or the emitter of the first input transistor (M1) to the source or the emitter of the second input transistor (M2) and capable of allowing the amplifier-comparator to output via the drain or the collector of the second input transistor (M2), a dual slope gain adjustment signal (I_{OUT}), if the deviation between the first input signal (V_{R}) and the second input signal (V_{P}) is greater or smaller than a defined threshold.

2. Electronic circuit (1) according to claim 1, **characterized in that** the first and second input transistors (M1, M2) are NMOS transistors, **in that** the first and second polarisation transistors (M5, M6) are NMOS transistors and **in that** the first and second current mirror transistors (M3, M4) are PMOS transistors.

3. Electronic circuit (1) according to claim 2, **characterized in that** the source of the first and second polarisation transistors is directly connected to the negative terminal (V_{SS}) of the supply voltage source, and **in that** the source of the first and second transistors (M3, M4) of the current mirror is directly connected to the positive terminal (V_{DD}) of the supply voltage source.

4. Electronic circuit (1) according to claim 1, **characterized in that** the first and second input transistors (M1, M2) are PMOS transistors, **in that** the first and second polarisation transistors (M5, M6) are PMOS transistors and **in that** the first and second current mirror transistors (M3, M4) are NMOS transistors.

5. Electronic circuit (1) according to claim 4, **characterized in that** the source of the first and second polarisation transistors is directly connected to the positive terminal (V_{DD}) of the supply voltage source, and **in that** the source of the first and second transistors (M3, M4) of the current mirror is directly connected to the negative terminal (V_{SS}) of the supply voltage source.

6. Electronic circuit (1) according to claim 1, **characterized in that** the non-linear transconductance element is formed of two pairs of transistors (M7, M8, M9, M10) having the same type of conductivity, series-connected between the source or emitter of the first input transistor (M1) and the source or emitter of the second input transistor (M2).

7. Electronic circuit (1) according to claim 6, **characterized in that** the two transistor pairs (M7, M8, M9, M10) are formed of NMOS transistors, **in that** the sources of the two transistors (M7, M8) of the first pair of transistors are connected to the source or emitter of the first input transistor (M1), **in that** the drains of the two transistors (M7, M8) of the first pair of transistors are connected to the sources of the two transistors (M9, M10) of the second pair of transistors (M9, M10), **in that** the drains of the two transistors (M9, M10) of the second pair of transistors are connected to the source or emitter of the second input transistor (M2), **in that** the gates of a first transistor (M7) of the first pair of transistors and of a first transistor (M9) of the second pair of transistors are connected to the gate or the base of the first input transistor (M1), and **in that** the gates of a second transistor (M8) of the first pair of transistors and of a second transistor (M10) of the second pair of transistors are connected to the gate or base of the second input transistor (M2).

8. Electronic circuit (1) according to claim 1, **characterized in that** the non-linear transconductance element is formed of a first diode-connected transistor (M17), of a second diode-connected transistor (M18) inversely to the first diode-connected transistor (M17), and of a resistor (R_{SS}), which are all connected in parallel and connected to the sources or emitters of the first and second input transistors (M1, M2).

9. Electronic circuit (1) according to claim 8, **characterized in that** the first and second diode-connected transistors (M17, M18) are PMOS transistors, **in that** the source of the first diode-connected transistor (M17) is connected to the source or emitter of the second input transistor (M2), **in that** the gate and the drain of the the first diode-connected transistor (M17) are connected to the source or emitter of the first input transistor (M1), **in that** the source of the second diode-connected transistor (M18) is connected to the source or emitter of the first input transistor (M1), and **in that** the gate and the drain of the second diode-connected transistor (M18) are connected to the source or the emitter of the second input transistor (M2).

10. Electronic circuit (1) according to claim 1, **characterized in that** the non-linear transconductance element is formed of a resistor (R_{SS}) connected to the sources or emitters of the first and second input transistors (M1, M2), of a first adaptation transistor (M13) having a first type of conductivity and of a second adaptation transistor (M14) having a first type of conductivity, **in that** the source or the emitter of the first adaptation transistor (M13) is connected to the source or emitter of the first input transistor (M1), **in that** the drain or collector of the first adaptation transistor (M13) is connected to the drain or to the collector of the second input transistor (M2), **in that** the source or the emitter of the second adaptation transistor (M14) is connected to the source or the emitter of the second input transistor (M2), **in that** the drain or the collector of the second adaptation transistor (M14) is connected to the drain or to the collector of the first input transistor (M1), and **in that** the gates or the bases of the first and second adaptation transistors (M13, M14) are connected to each other to receive an adaptation voltage (V_{CLIP}) in order to adapt the dual slope gain adaptation threshold of the non-linear amplifier-comparator (4).

11. Electronic circuit (1) according to any of claims 1 and 10, **characterized in that** the defined gain adaptation threshold of the non-linear amplifier-comparator (4) is set according to a deviation between the first reference signal (V_{R}) which is a reference voltage, and the second reference signal (V_{P}), which is a peak voltage delivered at the output of a peak detector (3), which is connected to the output of the input amplifier (2), if the peak voltage (V_{P}) deviates by more than 5 or 10% from the reference voltage (V_{R}), the defined threshold is exceeded for gain adaptation with a steep slope, while for a voltage deviation below the defined threshold, the gain adaptation is performed with a gentle slope.
